# EUROPÄISCHE PATENTANMELDUNG

(11) **EP 3 702 922 A1**
(43) Veröffentlichungstag der Anmeldung: **02.09.2020**
(21) Anmeldenummer: 19159924.0
(22) Anmeldetag: 28.02.2019
(51) Int. Cl.: G06F 11/36, G06F 17/50

(54) **VERFAHREN ZUR RECHNERGESTÜTZTEN VALIDIERUNG VON EINGEBETTETER SOFTWARE**

(71) Anmelder: Siemens Aktiengesellschaft, 80333 München (DE)
(72) Erfinder: Liu, Kai, 90562 Heroldsberg (DE); Wagner, Christian, 90411 Nürnberg (DE)

(57) **Zusammenfassung**

Die Erfindung betrifft ein Verfahren zur rechnergestützten Validierung von eingebetteter Software (SW), welche bei Fertigstellung in einer realen Hardwareumgebung zu integrieren ist, wobei die Software (SW) auf einer Rechnereinrichtung (HM) ausgeführt wird, welche die reale Hardwareumgebung simuliert. Auf der Rechnereinrichtung (HM) läuft eine virtuelle Maschine (VM), auf der die Software (SW) ausgeführt wird, wobei im Rahmen der Ausführung auf der virtuellen Maschine (VM) i) die Software (SW) auf eine oder mehrere in der virtuellen Maschine (VM) hinterlegte Funktionsroutinen (FR) zugreift, welche jeweils eine Funktion ohne Kopplung an eine simulierte Hardwarekomponente (P1, P2) ausführen; ii) die Software (SW) ferner über eine virtuelle Schnittstelle (VSI), welche durch die virtuelle Maschine (VM) bereitgestellt ist, auf eine oder mehrere simulierte Hardwarekomponenten (P1, P2) in einer Simulationsumgebung (SE) zugreift, die auf der Rechnereinrichtung (HM) läuft, wobei die simulierte oder simulierten Hardwarekomponenten (P1, P2) realen Hardwarekomponenten in der realen Hardwareumgebung entsprechen.

## Beschreibung

Im Rahmen der Entwicklung von eingebetteter Software (embedded software), welche in einer entsprechender Hardwareumgebung zu integrieren ist, besteht oftmals der Wunsch, die Software bereits zu einem Zeitpunkt zu validieren bzw. zu prüfen, an dem die reale Hardware noch nicht verfügbar ist. Um dies zu ermöglichen, ist es aus dem Stand der Technik bekannt, die Hardwareumgebung geeignet zu simulieren, so dass die eingebettete Software auf der simulierten Hardwareumgebung ausgeführt werden kann.

Bei der Ausführung von eingebetteter Software in einer simulierten Hardwareumgebung sind verschiedene Faktoren relevant. Um sicherzustellen, dass die simulierte Hardwareumgebung die reale Hardwareumgebung richtig wiedergibt, sollten alle Hardwarekomponenten, die von der eingebetteten Software benötigt werden, richtig modelliert sein. Gegebenenfalls kann bei der Simulation der Hardwareumgebung auch eine geeignete Abstraktion vorgenommen werden, bei der nur Informationen, die von der eingebetteten Software tatsächlich benötigt werden, in der virtuellen Hardwareumgebung modelliert werden. Beispielsweise können Implementierungsdetails weggelassen werden. Darüber hinaus ist zu beachten, dass die simulierte Hardwareumgebung derart ausgestaltet sein sollte, dass sie eine ausreichende Simulations-Performanz in dem Sinne gewährleistet, dass die Ausführung der eingebetteten Software in der simulierten Hardwareumgebung nicht übermäßig Zeit in Anspruch nimmt.

In Abhängigkeit von der Priorisierung der obigen Faktoren gibt es im Stand der Technik zwei unterschiedliche Verfahren, um Software zu validieren. Ein erstes Verfahren ist die sog. Host-basierte Simulation, bei der die eingebettete Software auf einem Abstraktionsniveau entwickelt wird und dabei auf abstrahierte Funktionalitäten zugreift, die durch einen Hardware-Representation-Layer gekapselt werden. Dieser Layer ist auf der Rechnereinrichtung (auch als Host bezeichnet) implementiert, auf der die eingebettete Software validiert wird. Mit der Host-basierten Simulation kann zwar eine hohe Simulations-Performanz erreicht werden, jedoch kann nur die abstrahierte eingebettete Software validiert werden, da die Gesamtheit der Hardwareumgebung bis hin zu den einzelnen Hardwarekomponenten nicht modelliert wird.

Gemäß einem zweiten Verfahren wird die Hardwareumgebung exakt basierend auf einer Simulationsumgebung simuliert. Diese Simulationsumgebung läuft auf einer Rechnereinrichtung (d.h. auf einem Host). Die eingebettete Software wird in der Simulationsumgebung ausgeführt. Hierdurch kann zwar das Verhalten der Software exakt für die entsprechende Hardwareumgebung prädiziert werden, jedoch ist die Simulations-Performanz sehr gering. Mit anderen Worten ist die Zeitspanne der Ausführung der Software in der Simulationsumgebung wesentlich höher, als wenn die Software auf der realen Hardware laufen würde.

Aufgabe der Erfindung ist es, ein Verfahren zur rechnergestützten Validierung von eingebetteter Software zu schaffen, welches auf einfache Weise das Verhalten der Software in der realen Hardwareumgebung mit hoher Simulations-Performanz simuliert.

Diese Aufgabe wird durch das Verfahren gemäß Patentanspruch 1 bzw. die Vorrichtung gemäß Patentanspruch 8 bzw. das Computerprogrammprodukt gemäß Patentanspruch 10 bzw. das Computerprogramm gemäß Patentanspruch 11 gelöst. Weiterbildungen der Erfindung sind in den abhängigen Ansprüchen definiert.

Das erfindungsgemäße Verfahren dient zur rechnergestützten Validierung von eingebetteter Software, welche bei Fertigstellung in einer realen Hardwareumgebung zu integrieren ist. Die eingebettete Software stellt von entsprechenden Entwicklern entwickelten Softwarecode nach seiner Kompilierung dar.

Bei der eingebetteten Software muss es sich nicht um die abschließend fertiggestellte Software handeln, sondern die Software kann auch eine temporär erzeugte Software sein, die im Rahmen der Entwicklung hin zur endgültigen Software erzeugt wird.

Die eingebettete Software wird erfindungsgemäß auf einer Rechnereinrichtung ausgeführt, welche die reale Hardwareumgebung simuliert. Der Begriff der Simulation der realen Hardwareumgebung ist dabei derart zu verstehen, dass die Simulation nicht alle Hardwarekomponenten der realen Hardwareumgebung modellieren braucht und auch bestimmte Funktionalitäten der Hardware abstrahiert werden können.

Im Rahmen des erfindungsgemäßen Verfahrens läuft auf einer Rechnereinrichtung eine virtuelle Maschine, auf der die Software ausgeführt wird. Im Rahmen dieser Ausführung greift die Software auf eine oder mehrere in der virtuellen Maschine hinterlegte Funktionsroutinen zu, welche jeweils eine Funktion ohne Kopplung an eine simulierte Hardwarekomponente ausführen. Der Begriff der Funktion ist dabei weit zu verstehen und umfasst in der Regel eine Vielzahl von Teilfunktionen bzw. Rechenoperationen. Da die Funktionsroutinen entkoppelt von simulierten Hardwarekomponenten sind, stellen sie eine Abstraktion der Hardware dar, wie sie im Stand der Technik durch den oben genannten Hardware-Representation-Layer realisiert werden kann.

Neben dem Zugriff auf die Funktionsroutinen greift die Software im Rahmen ihrer Ausführung ferner auf eine oder mehrere simulierte Hardwarekomponenten in einer Simulationsumgebung zu, die auf der Rechnereinrichtung läuft. Der Zugriff erfolgt über eine virtuelle Schnittstelle, welche durch die virtuelle Maschine bereitgestellt ist. Die simulierte oder simulierten Hardwarekomponenten entsprechen realen Hardwarekomponenten in der realen Hardwareumgebung.

Das erfindungsgemäße Verfahren zeichnet sich dadurch aus, dass in geeigneter Weise die oben beschriebene Host-basierte Simulation mit der oben beschriebenen Simulation basierend auf einer Simulationsumgebung kombiniert wird. Je nach Stand der Softwareentwicklung können dabei bestimmte Hardwarekomponenten exakt mittels der Simulationsumgebung modelliert werden, wohingegen andere Funktionalitäten lediglich durch Funktionsroutinen ohne direkte Kopplung an Hardwarekomponenten repräsentiert werden. Um dies zu erreichen, wird erfindungsgemäß eine virtuelle Schnittstelle genutzt, die üblicherweise in bekannten virtuellen Maschinen bereits vorhanden ist und demzufolge nicht neu programmiert werden muss. In einer bevorzugten Ausführungsform handelt es sich bei der virtuellen Schnittstelle um die sog. PCIe-Schnittstelle (PCIe = Peripheral Component Interconnect Express).

Durch die Verknüpfung der Host-basierten Simulation mit einer Simulation in einer Simulationsumgebung kann eine gute Simulations-Performanz im Hinblick auf geringe Simulationszeit erreicht werden, wobei jedoch adaptiv im Rahmen der Entwicklung der Software festgelegt werden kann, welche Teile der Hardware ggf. exakt modelliert werden sollen.

In einer bevorzugten Ausführungsform läuft auf der virtuellen Maschine das Betriebssystem Linux. Alternativ oder zusätzlich kann Linux auch als Betriebssystem der Rechnereinrichtung verwendet werden. Linux wird häufig im Zusammenhang mit der Validierung von eingebetteter Software in virtuellen Hardwareumgebungen genutzt. Nichtsdestotrotz kann auf der virtuellen Maschine und/oder auf der Rechnereinrichtung ggf. auch ein anderes Betriebssystem, wie z.B. Windows, zum Einsatz kommen.

In einer weiteren bevorzugten Ausführungsform ist die Simulationsumgebung basierend auf der Sprache SystemC modelliert. Diese Sprache wird häufig von Entwicklern im Zusammenhang mit der Erstellung von Simulationsumgebungen zur Repräsentation realer Hardwareumgebungen genutzt.

Die virtuelle bzw. virtuellen Hardwarekomponenten können je nach Ausgestaltung unterschiedliche Komponenten umfassen. In einer bevorzugten Ausführungsform stellen die virtuellen Hardwarekomponenten einen oder mehrere Schnittstellen-Controller, wie z.B. einen USB-Controller, einen Ethernet-Controller und dergleichen, dar. Diese Hardwarekomponenten lassen sich sehr gut in Simulationsumgebungen modellieren, ohne dass die Simulation sehr zeitaufwändig wird. Nichtsdestotrotz lassen sich ggf. auch andere virtuelle Hardwarekomponenten, wie z.B. ein Speicher oder ein Prozessor, in der Simulationsumgebung modellieren.

In einer weiteren bevorzugten Ausführungsform führen die Funktionsroutine oder Funktionsroutinen jeweils eine Funktion aus, welche durch einen Prozessor und/oder einen Speicher in der realen Hardwareumgebung realisierbar ist. Es wird somit davon ausgegangen, dass die Funktion der entsprechenden Funktionsroutine durch einen bestimmten Typ einer Hardwarekomponente realisiert werden kann, wobei jedoch die Funktionsroutine selbst nicht die Hardwarekomponente implementiert.

Das erfindungsgemäße Verfahren kann für Software in beliebigen Hardwareumgebungen zum Einsatz kommen. In einer bevorzugten Variante betrifft die Hardwareumgebung eine oder mehrere Steuereinrichtungen in einer Automatisierungsanlage, d.h. die Rechnereinrichtung simuliert eine oder mehrere Steuereinrichtungen in einer Automatisierungsanlage. Bei einer Steuereinrichtung kann es sich beispielsweise um eine Motorsteuerung für einen Motor in der Automatisierungsanlage handeln.

Neben dem oben beschriebenen Verfahren betrifft die Erfindung eine Vorrichtung zur rechnergestützten Validierung von eingebetteter Software, welche bei Fertigstellung in einer realen Hardwareumgebung zu integrieren ist, umfassend eine Rechnereinrichtung zur Simulation der realen Hardwareumgebung und zur Ausführung der Software. Die Vorrichtung ist dabei derart ausgestaltet, dass das erfindungsgemäße Verfahren bzw. eine oder mehrere bevorzugte Varianten des erfindungsgemäßen Verfahrens mit der Vorrichtung ausführbar sind.

Die Erfindung umfasst darüber hinaus ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer (d.h. der in Anspruch 1 definierten Rechnereinrichtung) ausgeführt wird.

Darüber hinaus betrifft die Erfindung ein Computerprogrammprodukt mit einem Programmcode zur Durchführung des erfindungsgemäßen Verfahrens bzw. einer oder mehrerer bevorzugter Varianten des erfindungsgemäßen Verfahrens, wenn der Programmcode auf einem Computer (d.h. der in Anspruch 1 definierten Rechnereinrichtung) ausgeführt wird.

Ein Ausführungsbeispiel der Erfindung wird nachfolgend anhand der beigefügten Figuren detailliert beschrieben.

Es zeigen:
- Fig. 1 und Fig. 2: schematische Darstellungen, welche die Validierung von eingebetteter Software gemäß zwei unterschiedlichen Verfahren nach dem Stand der Technik zeigen; und
- Fig. 3: eine schematische Darstellung, die eine Ausführungsform des erfindungsgemäßen Verfahrens wiedergibt.

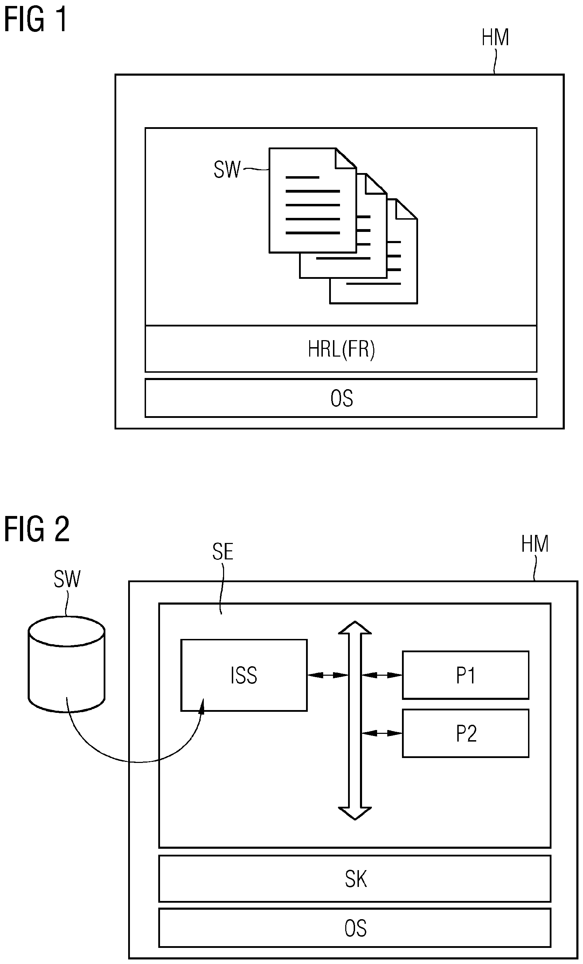

Bevor auf das erfindungsgemäße Verfahren eingegangen wird, werden zunächst anhand von Fig. 1 und Fig. 2 bekannte Verfahren zur Validierung von eingebetteter Software und deren Nachteile erläutert. Diese bekannten Verfahren wurden auch in der Beschreibungseinleitung genannt.

Fig. 1 zeigt eine sog. Host-basierte Simulation, bei der die eingebettete Software SW auf einer oberen Schicht mit einem Abstraktionsgrad in einer Host-Maschine HM läuft, auf der ein Betriebssystem OS (z.B. Linux) verwendet wird. Hierzu wird ein Hardware-Representation-Layer HRL genutzt, in dem Funktionsroutinen FR implementiert sind, die keinen Hardwarekomponenten zugeordnet sind, sondern lediglich allgemein Funktionalitäten der Hardware beschreiben. Die Software ist somit auf einem hohen Abstraktionsniveau unter Verwendung des Hardware-Representation-Layers HRL programmiert und auf der Host-Maschine HM kompiliert. Aufgrund dieser Abstraktion kann eine hohe Simulations-Performanz erreicht werden, da Hardwareaktivitäten geeignet durch den Hardware-Representation-Layer vereinfacht werden. Es ist jedoch nicht möglich, die Hardware im Detail abzubilden, so dass die Software nicht vollumfänglich validiert werden kann.

Im Unterschied zu Fig. 1 zeigt Fig. 2 die Validierung von eingebetteter Software unter Verwendung einer Simulationsumgebung SE. Die Simulationsumgebung SE basiert auf dem Simulations-Kernel SK, der in einer bevorzugten Variante basierend auf der an sich bekannten Programmiersprache SystemC erstellt ist. Die Simulationsumgebung läuft auf einer Host-Maschine HM mit Betriebssystem OS (z.B. Linux). Im Unterschied zu dem Hardware-Representation-Layer HRL der Fig. 1 werden nunmehr alle Hardwarekomponenten der Hardwareumgebung mittels der Simulationsumgebung SE simuliert. Üblicherweise wird dabei zur Simulation eines Prozessors der sog. Instruction-Set-Simulator verwendet. Beispielhaft ist eine derart simulierte Komponente mit ISS in Fig. 2 angegeben. Andere Komponenten werden häufig durch abstrakte Modelle modelliert. Als Beispiel sind in Fig. 2 zwei Schnittstellen P1 und P2 als weitere simulierte Hardwarekomponenten angegeben. Üblicherweise enthält die Simulationsumgebung SE eine Vielzahl von weiteren Komponenten, die aus Übersichtlichkeitsgründen nicht in Fig. 2 wiedergegeben sind.

Zur Validierung der Software SW in der Simulationsumgebung SE wird die kompilierte Software in diese Umgebung übertragen und dort direkt auf den simulierten bzw. virtuellen Hardwarekomponenten ausgeführt. Mit diesem Verfahren können alle Hardwarekomponenten ohne Beschränkung simuliert werden, so dass die Software vollumfänglich vor deren Einsatz in der realen Hardwareumgebung validiert werden kann. Der Nachteil dieser Methode besteht jedoch in der geringen Simulations-Performanz, da die gesamte Hardware simuliert wird. Oftmals liegt ein Zeitfaktor von 100 zwischen der Ausführung der eingebetteten Software in der Simulationsumgebung und der Ausführung der eingebetteten Software auf realer Hardware. Darüber hinaus ist der Aufwand für die Erstellung der Simulationsumgebung in der Regel sehr hoch, da alle virtuellen Hardwarekomponenten geeignet modelliert werden müssen.

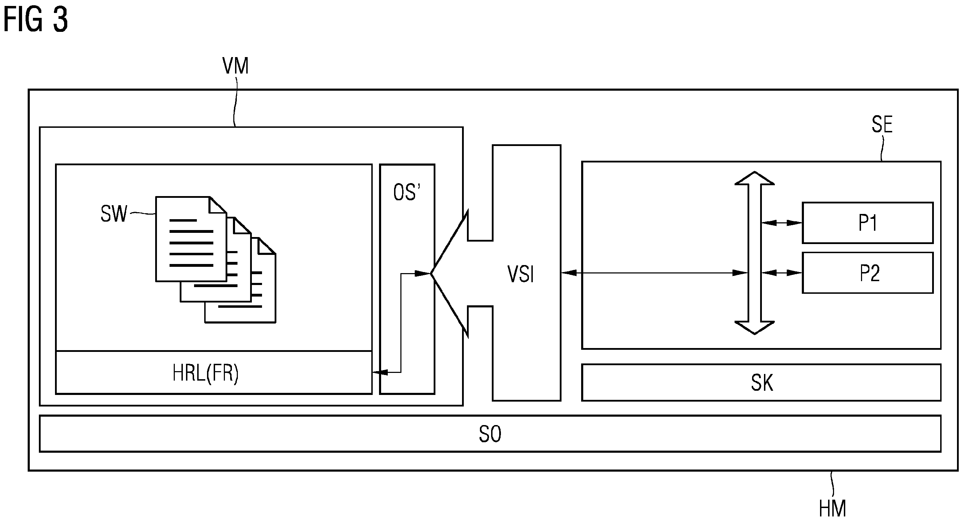

Fig. 3 zeigt eine schematische Darstellung einer Ausführungsform des erfindungsgemäßen Verfahrens, das die beiden oben beschriebenen bekannten Verfahren miteinander kombiniert, um sich so die Vorteile beider Verfahren zu Nutze zu machen und deren Nachteile weitestgehend zu vermeiden. Gemäß Fig. 3 läuft das Verfahren wiederum auf einer Host-Maschine HM, auf der das Betriebssystem OS (z.B. Linux) implementiert ist. Die zu testende Software SW wurde unter Verwendung des oben genannten Hardware-Representation-Layers HRL entwickelt, wobei bei der Entwicklung auch virtuelle Hardwarekomponenten berücksichtigt wurden.

In der Host-Maschine HM ist eine virtuelle Maschine VM implementiert, auf der die eingebettete Software SW läuft. Die Software greift dabei auf entsprechende Funktionsroutinen FR des Hardware-Representation-Layers HRL zu. Die virtuelle Maschine VM verwendet ihr eigenes Betriebssystem OS', welches jedoch dem Betriebssystem OS der Host-Maschine HM entsprechen kann.

Im Unterschied zu einer reinen Host-basierten Simulation greift die eingebettete Software SW auch auf eine Simulationsumgebung SE zu, in der ein Teil der Hardwarekomponenten der Hardwareumgebung simuliert ist, auf der die Software später laufen soll. Beispielhaft sind in Fig. 3 als simulierte Hardwarekomponenten zwei Schnittstellen P1 und P2 angegeben. Erfindungswesentlich ist nunmehr, dass eine Verknüpfung der Simulationsumgebung SE mit der Host-basierten Simulation auf einfache Weise mit einer virtuellen Schnittstelle VSI erreicht wird, die üblicherweise durch eine virtuelle Maschine bereitgestellt wird und somit nicht separat programmiert werden muss.

In der hier beschriebenen Ausführungsform wird eine virtuelle PCIe-Schnittstelle als virtuelle Schnittstelle VSI der virtuellen Maschine VM genutzt. Dabei greift die Software SW über den Hardware-Representation-Layer HRL mittels des Kernel-Treibers des Betriebssystems OS' auf die simulierten bzw. virtuellen Hardwarekomponenten P1 und P2 zu. In der virtuellen PCIe-Schnittstelle werden die entsprechenden Transaktionen, die durch die Host-basierte Simulation initiiert werden, auf die virtuellen Hardwarekomponenten P1 bzw. P2 umgelenkt, die in der Simulationsumgebung SE laufen. Analog können Befehle, die in der Simulationsumgebung SE durch die entsprechenden Hardwarekomponenten ausgegeben werden, über die virtuelle Schnittstelle VSI an die Host-basierte Simulation zur Weiterverarbeitung gegeben werden. Insbesondere werden Interrupts, die durch die virtuellen Hardwarekomponenten erzeugt werden, an die Host-basierte Simulation mittels der virtuellen Schnittstelle VSI gesandt. Die Host-basierte Simulation registriert dabei für die Interrupt-Ereignisse sog. Callbacks, die im Hardware-Representation-Layer HRL durch den Kernel-Treiber bereitgestellt werden. Die Callbacks werden ausgeführt, falls entsprechende Interrupts durch virtuelle Hardwarekomponenten ausgegeben werden.

Die im Vorangegangenen beschriebene Ausführungsform der Erfindung weist eine Reihe von Vorteilen auf. Insbesondere wird eine hohe Simulations-Performanz, d.h. eine geringe Ausführungszeit der Software in der simulierten Hardwareumgebung, aufgrund der Verwendung einer Host-basierten Simulation in einer virtuellen Maschine erreicht. Nichtsdestotrotz werden einige Hardwarekomponenten auch exakt in einer Simulationsumgebung simuliert. Dabei können je nach Entwicklungsstadium der Software inkrementell weitere virtuelle Hardwarekomponenten hinzugefügt werden.

Über die Verwendung einer virtuellen Schnittstelle, die in einer virtuellen Maschine bereits vorhandenen ist, kann auf einfache Weise die Verknüpfung einer Simulationsumgebung mit einer Host-basierten Simulation erreicht werden. Im Besonderen ist es nicht erforderlich, dass zur Wechselwirkung zwischen der Simulationsumgebung der Host-basierten Simulation eine eigene Schnittstelle programmiert werden muss. Die virtuelle Schnittstelle schafft dabei die Verbindung zwischen der abstrakten Host-basierten Simulation und der Simulationsumgebung.

Eine entsprechende virtuelle Schnittstelle kann in an sich bekannten Entwicklungswerkzeugen implementiert werden. Dabei wird den Entwicklern, welche das Entwicklungswerkzeug nutzen, eine hohe Flexibilität bei der Validierung der Software in verschiedenen Entwicklungsstadien gegeben. Insbesondere kann eine abstrakte Simulation zu Beginn der Entwicklung der eingebetteten Software genutzt werden, welche schließlich hin zum Ende der Softwareentwicklung immer weiter durch virtuelle Hardwarekomponenten ergänzt wird, bis schließlich die endgültige Software mittels der Simulationsumgebung validiert werden kann.

## Patentansprüche

1. Verfahren zur rechnergestützten Validierung von eingebetteter Software (SW), welche bei Fertigstellung in einer realen Hardwareumgebung zu integrieren ist, wobei die Software (SW) auf einer Rechnereinrichtung (HM) ausgeführt wird, welche die reale Hardwareumgebung simuliert,
dadurchgekennzeichnet, dass auf der Rechnereinrichtung (HM) eine virtuelle Maschine (VM) läuft, auf der die Software (SW) ausgeführt wird, wobei im Rahmen der Ausführung auf der virtuellen Maschine (VM)
i) die Software (SW) auf eine oder mehrere in der virtuellen Maschine (VM) hinterlegte Funktionsroutinen (FR) zugreift, welche jeweils eine Funktion ohne Kopplung an eine simulierte Hardwarekomponente (P1, P2) ausführen;
ii) die Software (SW) ferner über eine virtuelle Schnittstelle (VSI), welche durch die virtuelle Maschine (VM) bereitgestellt ist, auf eine oder mehrere simulierte Hardwarekomponenten (P1, P2) in einer Simulationsumgebung (SE) zugreift, die auf der Rechnereinrichtung (HM) läuft, wobei die simulierte oder simulierten Hardwarekomponenten (P1, P2) realen Hardwarekomponenten in der realen Hardwareumgebung entsprechen.

2. Verfahren nach Anspruch 1, **dadurch gekennzeichnet, dass** die virtuelle Schnittstelle (VSI) eine PCIe-Schnittstelle (PCIe = Peripheral Component Interconnect Express) ist.

3. Verfahren nach Anspruch 1 oder 2, **dadurch gekennzeichnet, dass** auf der virtuellen Maschine (VM) und/oder auf der Rechnereinrichtung (HM) das Betriebssystem Linux läuft.

4. Verfahren nach einem der vorhergehenden Ansprüche, **dadurch gekennzeichnet, dass** die Simulationsumgebung (SE) basierend auf der Sprache SystemC modelliert ist.

5. Verfahren nach einem der vorhergehenden Ansprüche, **dadurch gekennzeichnet, dass** die virtuelle oder die virtuellen Hardwarekomponenten (P1, P2) eine oder mehrere Schnittstellen-Controller umfassen.

6. Verfahren nach einem der vorhergehenden Ansprüche, **dadurch gekennzeichnet, dass** die Funktionsroutine (FR) oder Funktionsroutinen (FR) jeweils eine Funktion ausführen, welche durch einen Prozessor und/oder einen Speicher in der realen Hardwareumgebung realisierbar ist.

7. Verfahren nach einem der vorhergehenden Ansprüche, **dadurch gekennzeichnet, dass** die Rechnereinrichtung (HM) eine oder mehrere Steuereinrichtungen in einer Automatisierungsanlage simuliert.

8. Vorrichtung zur rechnergestützten Validierung von eingebetteter Software (SW), welche bei Fertigstellung in einer realen Hardwareumgebung zu integrieren ist, umfassend eine Rechnereinrichtung (HM) zur Simulation der realen Hardwareumgebung und zur Ausführung der Software (SW),
dadurchgekennzeichnet, dass die Rechnereinrichtung (HM) derart ausgestaltet ist, dass auf der Rechnereinrichtung (HM) in deren Betrieb eine virtuelle Maschine (VM) läuft, auf der die Software (SW) ausgeführt wird, wobei im Rahmen der Ausführung auf der virtuellen Maschine (VM)
i) die Software (SW) auf eine oder mehrere in der virtuellen Maschine (VM) hinterlegte Funktionsroutinen (FR) zugreift, welche jeweils eine Funktion ohne Kopplung an eine simulierte Hardwarekomponente (P1, P2) ausführen;
ii) die Software (SW) ferner über eine virtuelle Schnittstelle (VSI), welche durch die virtuelle Maschine (VM) bereitgestellt ist, auf eine oder mehrere simulierte Hardwarekomponenten (P1, P2) in einer Simulationsumgebung (SE) zugreift, die auf der Rechnereinrichtung (HM) läuft, wobei die simulierte oder simulierten Hardwarekomponenten (P1, P2) realen Hardwarekomponenten in der realen Hardwareumgebung entsprechen.

9. Vorrichtung nach Anspruch 8, **dadurch gekennzeichnet, dass** die Vorrichtung zur Durchführung eines Verfahrens nach einem der Ansprüche 2 bis 7 eingerichtet ist.

10. Computerprogrammprodukt mit einem auf einem maschinenlesbaren Träger gespeicherten Programmcode zur Durchführung eines Verfahrens nach einem Ansprüche 1 bis 7, wenn der Programmcode auf einem Computer ausgeführt wird.

11. Computerprogramm mit einem Programmcode zur Durchführung eines Verfahrens nach einem der Ansprüche 1 bis 7, wenn der Programmcode auf einem Computer ausgeführt wird.
